Europäisches Patentamt

European Patent Office

Office européen des brevets

(19)

(11) Publication number : **0 119 742 B2**

# NEW EUROPEAN PATENT SPECIFICATION

(12)

(45) Date of publication of the new patent specification : **16.12.92 Bulletin 92/51**

(51) Int. Cl.⁵ : **H01L 31/08**

(21) Application number : **84300990.3**

(22) Date of filing : **15.02.84**

(54) **Two-dimensional image readout device.**

(30) Priority : **15.02.83 JP 24307/83**
**03.03.83 JP 35608/83**

(43) Date of publication of application :
**26.09.84 Bulletin 84/39**

(45) Publication of the grant of the patent :
**21.06.89 Bulletin 89/25**

(45) Mention of the opposition decision :
**16.12.92 Bulletin 92/51**

(84) Designated Contracting States :
**DE FR GB**

(56) References cited :
**EP-A- 0 053 946**
**DE-A- 2 349 233**
**DE-A- 2 828 390**
**DE-A- 3 111 746**
**GB-A- 2 029 642**

(56) References cited :
**JP-A-56 146 360**
**US-A- 3 435 138**
**US-A- 3 544 713**
**US-A- 4 247 874**
**US-A- 4 271 435**
**PATENT ABSTRACTS OF JAPAN, vol. 6, no. 25 (E-94) [903], 13th February 1982 & JP-A-56-146 360**

(73) Proprietor : **SHARP KABUSHIKI KAISHA**
**22-22 Nagaike-cho Abeno-ku**
**Osaka 545 (JP)**

(72) Inventor : **Itoh, Masataka**
**2613-1 Ichinomoto-cho**
**Tenri-shi Nara-ken (JP)**
Inventor : **Katoh, Shohichi**
**476-90 Hieda-cho**
**Yamatokoriyama-chi Nara-ken (JP)**

(74) Representative : **Wright, Peter David John et al**
**R.G.C. Jenkins & Co. 26 Caxton Street**
**London SW1H 0RJ (GB)**

EP 0 119 742 B2

## Description

This invention relates to an image readout device, and more particularly it relates to a two-dimensional image readout device in which sensor elements are disposed in a two-dimensional manner.

In past years, MOS image sensors, CCD sensors, and contact type image sensors have been proposed as devices suitable for the read out of an image in telecopier or facsimile machines. The MOS type image sensor is a device by which incident images are scanned with an MOSIC and converted into electric signals through opto-electric transducers. The CCD sensor is a device in which light-induced charges at optoelectric converting areas are transferred through charge-coupled elements (CCD).

It is, however, inconvenient from functional and economical points of view to make MOS type or CCD type sensors of large area since these sensors rely upon the IC technique for buildup thereof on a monocrystalline substrate. Generally, an optical lens is used for scaling-down and focusing of an image of an original onto a smaller sensor. This method has the disadvantages that the optical paths are longer because of the use of the optical lens and it is therefore difficult to reduce the machine to a compact size.

To improve the above scaling-down/focusing type of image sensor, the contact type image sensor has been proposed which uses a sensor of the same size as the original and an optical fibre for focusing an image of the same size as the original. For the contact type image sensor, an opto-electric converting area of the same dimensions as the original is necessary which requires deposit of a uniform layer of a photoconductor over a large area. An example of a one-dimensioned contact type of image sensor which has been suggested has a CdS photoconductive layer divided into individual islands. This device is however complicated in structure because the photoconductive layer must be divided during manufacture and individual electrodes provided for the respective islands of the photoconductive layer. Another problem with this device is that readout speed is limited mainly due to the light response speed of the photoconductive layer. In particular, the CdS photoconductive layer is poor in light response speed and applicability of this device as a one-dimensional image sensor is therefore substantially restricted.

Another contact type of sensor has been proposed which has a strip-shaped photoconductor using amorphous silicon. If a two-dimensional image is to be read out with this type of one-dimensional sensor, then the sensor will be repeatedly used and the same portion of the sensor must be supplied with a voltage in a cyclic manner for readout of signals. The current variations in response to brightness variations between "light" and "dark", that is, rising and falling characteristics, directly affect readout signals and impose limits on readout speed. These outstanding problems must be solved for putting two-dimensional image sensors into practical use.

Accordingly, it is desirable to provide a novel structure for a two-dimensional image readout device which overcomes the foregoing problems and especially is effective not only for conventional contact type image sensors but also for two-dimensional image sensors.

It is also desirable to provide a two-dimensional image readout device in which optical and electric scanning is carried out on working surfaces of the sensor with a minimum of electrode readout terminals.

According to the invention there is provided a two-dimensional readout device having an image sensor comprising an array of optical sensing regions, the sensor being arranged to produce an output representing a two-dimensional image being read by the device, characterised in that said optical sensing regions are arranged in the form of a two-dimensional matrix, each optical sensing region being located at the intersections of a plurality of parallel X electrodes and a plurality of parallel Y electrodes, and said device has optical scanning means presenting successive linear regions of the image to respective lines of the matrix of sensing regions in a sequential manner and means responsive to the presentation of said successive linear regions generating successive signals each representing a respective said linear image region.

With this device, even if a photoconductive layer disposed between the X and Y electrodes manifests poor light response, sensor operation is not adversely affected and higher readout speed can be ensured than in the conventional one-dimensional sensors. Furthermore, since a real-size image is projected onto the sensor device for readout, it allows greatest flexibility for design of the electrode structure. This flexibility, combined with simplicity of structure makes it very easy to manufacture the sensor device. Thus, inexpensive two-dimensional image readout devices are provided.

In order that the invention may be better understood, two embodiments thereof will be described, by way of example, with reference to the accompanying drawings, in which:

Fig. 1(a) is a perspective view of a sensor device according to the present invention;

Fig. 1(b) is a cross sectional view of the sensor device of Fig. 1(a).

Fig. 2 is a circuit diagram of the sensor device of Fig. 1;

Fig. 3 is a schematic view showing coupling with an optical system;

Fig. 4 is a schematic view of a second sensor device according to the present invention;

Figs. 5(a) and 5(b) are equivalent circuit diagrams of a sensor element according to the invention; and

Fig. 6 is a perspective view of a further sensor device according to the invention.

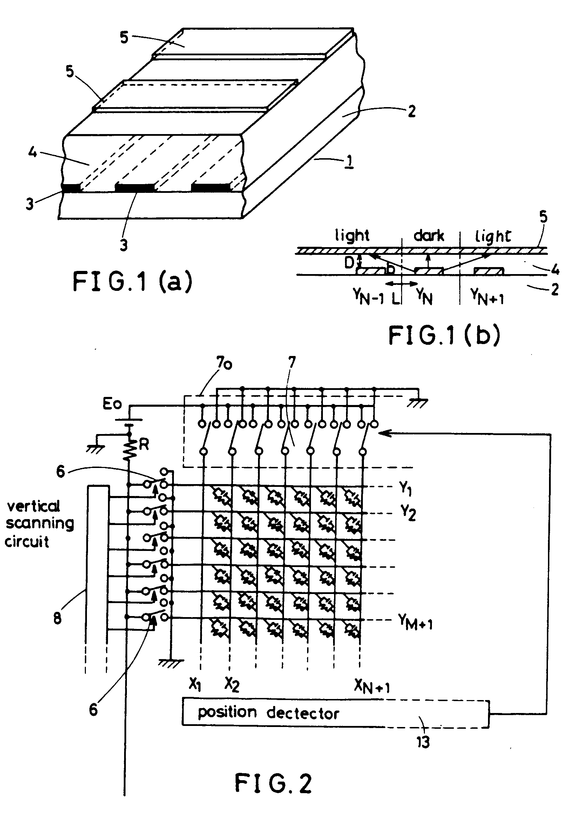

In Fig. 1 the sensor 1 comprises a substrate 2 of insulating material such as glass having substantially the same area as that of a two-dimensional image to be read out, and Y electrodes 3 equally spaced in parallel by deposit of Al or the like on a surface of the substrate 2. Since the width and pitch of the respective Y electrodes 3 influences the resolution of the sensor 1, it is desirable that those dimensions be as small as possible within a range permissible according to the light output characteristics of a photoconductive layer of a predetermined thickness.

There is disposed a photoconductive layer 4 over the substrate 2 having the Y electrodes 3 thereon. The photoconductive layer 4 contains a mixture, mainly of photoconductive CdS particles dispersed in resin material, overlying the whole area of a two-dimensional plane on the substrate 2 with a uniform thickness. Further disposed on the photoconductive layer 4 are X electrodes 5 in a direction normal to the Y electrodes 3 with substantially the same pitch as the Y electrodes 3. To permit readout of the image, the X electrodes 5 are made up of transparent conducting material. Alternatively, if the substrate 2 is made of transparent insulating material and the Y electrodes 3 are also made of transparent electrode material, the Y electrode side of the substrate may be used as the image input side and the X electrodes 5 may be made of Al or the like. It is noted that the distance D between the X and Y electrodes sandwiching the photoconductive material 4 and the spacing L between the Y electrodes 3 are correlated as $L > D$. In a representative example of the sensor device, $L = 50$ $\mu$m and $D = 20$ $\mu$m.

The image is projected onto the sensor device of the above described electrode structure. A cross sectional view of the structure including the X electrode 5 and the Y electrodes $Y_{N-1}$, $Y_N$ and $Y_{N+1}$, is illustrated in Fig. 1(b), wherein a "dark" image is applied only to the Nth electrode YN. Should the distances L, D be correlated as $L < D$, the current flowing along a slanting path b will become large. As a result, a substantial amount of current will flow through the $Y_N$ electrode which is subject to the "dark" image due to the neighboring "light" image states, markedly impairing the accuracy of image readout at the intersections of the X and Y electrodes. However, in the case where $L > D$ as in Figure 1, current flowing along the slanting direction b is negligible because of the smaller distance D. In this case image information on the electrodes can be converted into electric signals with a higher degree of accuracy. A sensor device 1 having the Y electrodes 3 and the X electrodes 5 sandwiching the two-dimensionally continuous photoconductive material 4 is equivalent to a device in which the sensor elements each comprise a separate photoconductive layer between a pair of opposing electrodes, i.e. a Y electrode 3 and an X electrode 5 arranged as par of a matrix of electrodes. Each of the elements can be represented by a parallel circuit of a capacitor C and a resistor R as shown in the equivalent circuit diagram of Fig. 2, where a plurality of such parallel circuits is arranged in a matrix. The X and Y electrodes of the sensor device 1 are connected to a power supply via switching elements 6, 7 for scanning these electrodes for image readout. The switching elements 6 connected to the Y electrodes 3 are switched on and off by a control signal from a vertical scanning circuit 8.

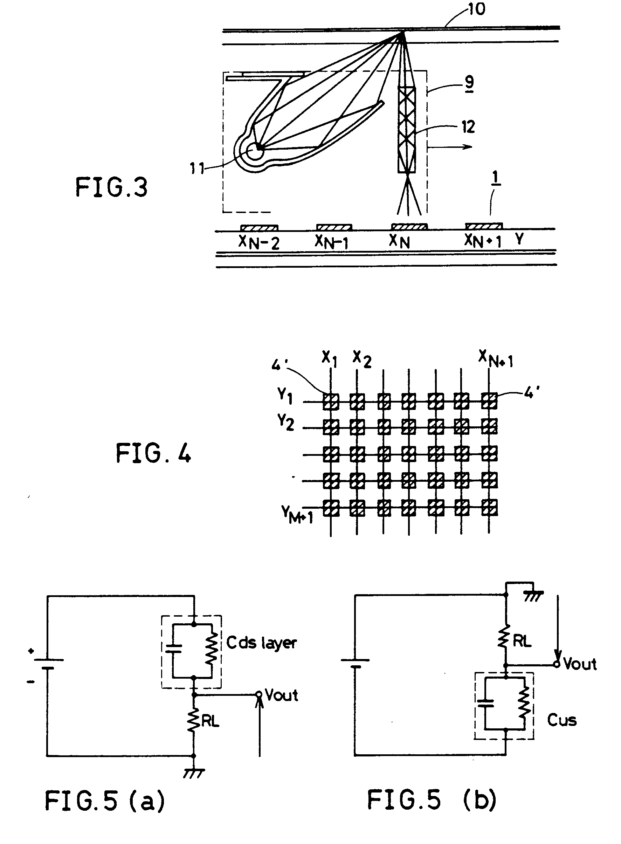

To transfer the image onto the sensor surface, the sensor device 1 is provided with an optical system 9 as shown in Fig. 3, for example. The optical system 9 comprises a light source 11 having a reflective surface for illuminating an original 10 with focused light beams, and a fibre optic lens 12 for leading reflective light from the original 10 to the line-shaped X electrodes 5 of the transparent material. Should the fibre optic lens 12 be located just above the Nth X electrode $X_N$, none of the electrodes except the Nth electrode $X_N$ is connected to the power supply, which is achieved through switching on of the switching element $7_N$. The switching elements 7 leading to the X electrodes 3 are switched on and off in the following manner. A position detector 13 shown in Fig. 2 sees the positional relationship between the fibre optic lens 12 and the sensor device 1 and an output signal from the position detector 13 is supplied to a switching control $7_0$ which includes the switching elements 7, so that a particular switching element $7_i$ associated with the $X_i$ electrode situated beneath the fibre optic lens 12 is connected to the power supply. As seen in equivalent circuits of Figs. 5(a) and 5(b), a voltage, negative or positive with respect to the ground, is supplied and an output signal is delivered through a load resistor $R_L$ between the photoconductive material and ground. Under these circumstances, the X and Y electrodes which are not connected to the voltage supply grounded via the vertical switching elements 6 and the horizontal switching elements 7.

To read out the two-dimensional image of the original 10, the optical system 9 moves with respect to the original 10 and the sensor device 1. In the illustrated embodiment, the optical system 9 moves at speed V in a direction from the $X_1$ electrode toward the $X_{N+1}$ electrode. While the optical system 9 is travelling at speed V, the Y electrodes are automatically scanned at scanning speed of more than M + 1 per X electrode (M + 1: the number of Y electrodes). Eventually, the image projected onto the electrode portions directly underneath the fibre optic lens 12 is converted into electric signals and then delivered from between the electrodes as readout signals from the photoconductive elements. Subsequent upon and in synchronism with movement of the optical system 9 an image signal on the neighboring X electrodes is read out. The two-dimensional original incident upon the whole of the sensor device 1 can be read out by sequentially switching the X electrodes 5. Two-dimensional scanning is possible by moving the original 10 and the sensor device 1 in the same direction and with the same speed instead of moving the optical system 9.

It is well known that the photoconductive material 4 becomes conductive upon being subjected to light radiation but shows a very high resistance against the surrounding "dark" portion. In any event the readout operation of the sensor device 1 will not be impaired in the illustrated embodiment wherein the photoconductive layer is not divided but continuous over the whole of the two-dimensional plane. Furthermore, it is possible to prevent crosstalk current due to matrix wiring if terminals other than those operative for voltage supply are connected to ground.

For example, for an A4 size original a readout device having a two-dimensional image sensor device of the above described structure with a density of 8 electrodes/mm and an area of 320 (X direction) x 230 (Y direction) mm$^2$ and 2560 X electrodes and 1840 Y electrodes, gave satisfactory image readout with good S/N ratio when the optical system travelled at a speed $V = 250$ mm/ sec, and the switching frequency of the Y electrodes was 4MHz. In other words an A4 original was scanned within about 1 sec. (0.5 msec/line). When the terminals other than those operative for voltage supply were grounded, leakage current could be reduced to a thousandth of that when they were not grounded, resulting in S/N ratio enhancement. In the case of a one-dimensional sensor using the same photoconductive material, a readout time of more than 50 msec/line was necessary in order to ensure the same S/N ratio as with the above detailed sensor device, and image readout operation was very slow. However, in the case of the above illustrated embodiment wherein the sensor portion was designed in two-dimensional manner and the image readout position of the sensor device was moved sequentially or scanned, high speed readout could be achieved without being affected by the light response characteristics of the photoconductive layer.

In Fig. 4, there is illustrated a schematic view of a sensor device according to another embodiment of the present invention. Like the above embodiment, this alternative embodiment is adapted such that there are disposed Y and X electrodes running in directions normal to each other over the insulating substrate 1 with intervening photoconductive layers 4'. The difference lies in that the photoconductive layers 4' are not continuous over the whole of the two-dimensional plane but independent and separate for each of the intersections of the matrix.

If the Y electrodes 3 are scanned and the X electrodes are sequentially switched in this embodiment, the device can deliver image read-out signals as a two-dimensional image sensor. Because the photoconductive layers in respective elements are separate, there is no flow of current into the adjacent electrodes via the photoconductive layers so that the sensor device is free from the distance limitation L > D as discussed with respect to the first embodiment. Similarly, if the electrodes with no voltage supplied are all grounded, then crosstalk current can be completely eliminated.

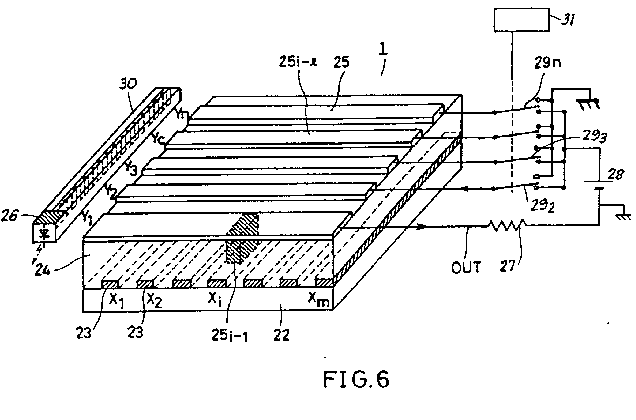

In Fig. 6, there is illustrated an embodiment of the present invention in which the sensor device similarly includes a substrate 22, strip-shaped X electrodes 23, a photoconductive layer 24 and Y electrodes 25 of transparent material. On the transparent Y electrode side, at least one of the n Y electrodes, for example the first electrode $Y_1$, is used as an electrode for selection of a particular X electrode $X_i$ from the group of X electrodes during image readout, while the remaining electrodes $Y_2$ to $Y_n$ are electrodes for makeup of an image sensor matrix. A switching light source 26 (e.g. LED) which illuminates a region corresponding to the width of a single X electrode is disposed against the electrode $Y_1$ for selection of the X electrodes. The electrode $Y_1$ itself is connected to one end of a power supply 28 via a resistor 27. The remaining electrodes $Y_2$ to $Y_n$ are connected commonly to the other end of the power supply 28 via switching elements $29_2$ to $29_n$. An optical fibre array 30 is secured against the electrodes $Y_2$ to $Y_n$ to transfer image information to the electrodes $Y_2$ to $Y_n$.

It is noted that the optical fibre array 30 is disposed in a straight line against the switching light source 26. The switching elements $29_2$ to $29_n$ are sequentially selected with signals from a scanning circuit 31 and in particular all of the elements are scanned once while the optical fibre array 30 is disposed over a particular X electrode. At this time the Y electrode terminals not connected to the power supply, are grounded through the switching elements. Terminal OUT is to deliver readout signals from the Y electrodes.

In operation, the switching light source 26 is enabled when the optical fibre array 30 is situated above a particular electrode $X_i$ of the X electrode group, rendering conductive a portion $25_{i\cdot 1}$ of the photoconductive layer sandwiched between the electrodes $X_i$ and $Y_1$. At the same time reflective light from an original 22 is incident upon the optical fibre array 30 and light signals indicative of image information are applied to the electrodes $Y_2$ to $Y_n$ adjacent to the particular electrode $Y_i$. To prevent light radiation on the photoconductive layer between the electrodes $Y_1$ and $Y_2$ from rendering conductive that portion of the photoconductive layer, light is shuttered between the electrodes $Y_1$ and $Y_2$ and the portion of the photoconductive layer between the electrodes $Y_1$ and $Y_2$. Under these circumstances where the switching elements $29_2$ to $29_n$ are sequentially turned on with signals from the scanning circuit 31, the portion of the photoconductive layer beneath each Y electrode is supplied with a light signal from the optical fibre array 30. That portion of the photoconductive layer is electrically coupled with the portion $25_{i-1}$, of the photoconductive layer underneath $Y_1$ which is conductive due to light from the light source, by way of the electrode $Y_i$. An electric circuit from the output terminal OUT is established to output image readout signals, because the power supply 28 is operative. In this embodiment, either the X or Y electrodes sandwiching the photoconductive material are optically scanned and the others are electrically scanned.

Whereas the photoconductive layer is CdS in the foregoing embodiments, good readout operation is available with other materials capable of exhibiting stable photoconductive characteristics over a wide area without difficulties, such as amorphous Si, amorphous Se, Se compounds and other organic semiconductor materials. The present invention should not be limited to the contact type sensor but is applicable to conventional image readout devices with a scaling-down lens.

**Claims**

1.  A two-dimensional image readout device having an image sensor (1) comprising an array of optical sensing regions, the sensor being arranged to produce an output representing a two-dimensional image (10) being by the device, characterised in that said optical sensing regions are arranged in the form of two-dimensional matrix, each optical sensing region being located at the intersections of a plurality of parallel X electrodes (5;25) and a plurality of parallel Y electrodes (3;23), and said device has optical scanning means (11,12;30) presenting sucessive linear regions of the image to respective lines of the matrix of sensing regions in a sequential manner and means (6,7,8;26,29) responsive to the presentation of said sucessive linear regions generating successive signals each representing a respective said linear image region.

2.  A two-dimensional image read-out device according to claim 1 wherein;
    said plurality of X electrodes (5) is disposed in a direction normal to said plurality of Y electrodes (3) and a photoconductive layer (4) is interposed between said X and Y electrodes, one or both of said pluralities of electrodes being made of transparent material; and wherein there is provided optical means (9) for projecting said linear regions of the image to the sensing regions; switching means (7) for selectively providing said respective lines of the matrix of sensing regions with a supply voltage; and control means (13) for synchronising the scanning of the sensing regions and the switching of the electrodes.

3.  A two-dimensional image readout device according to claim 2 wherein;
    said supply voltage, positive or negative with respect to ground, is supplied to a selected line of sensing regions via a selected one of said electrodes, and, of said X and Y electrodes other than said selected electrode, either or both pluralities of X and Y electrodes are grounded, so that current flowing through sensing regions of the selected line thereof is delivered as an output voltage via a load resistor disposed between the photoconductive layer and ground.

4.  A two-dimensional image read-out device according to claim 2 wherein there are provided;
    scanning switches (29) connected to respective electrodes (25) of one of the pluralities of electrodes, said plurality of electrodes being transparent;
    a power supply (28) connected between one of said transparent electrodes (25) and the remaining electrodes of that plurality via said scanning switches (29);
    an optical system (30) for presenting the image to be read out to the transparent electrodes other than said one of said transparent electrodes;
    a switching light source (26) which faces said one of said transparent electrodes and is arranged to move relative to the sensor along said one of said transparent electrodes so that when said light source is switched on a portion of the photoconducting layer, determined by the instaneous position of the switching light source, is activated so that a path is completed between a selected one of the second plurality of electrodes (23) and the power supply via said one of the transparent electrodes.

5.  A two-dimensional image read-out device according to claim 4, wherein said switching light source (26) is integral with said optical system (30) for presenting the image information to said transparent electrodes (25).

6.  A two-dimensional image read-out device according to claim 4 or claim 5, wherein said transparent electrodes (25) other than said one for power supply are selectively grounded or connected to the power supply (28) via said scanning switches (29).

7.  A two-dimensional image read-out device according to any claims 2 to 6 wherein said photoconductive layer (4) extends continuously between a plurality of the X and Y electrode pairs.

8. A two-dimensional image read-out device according to any of claims 2 to 6 wherein said photoconductive layer is divided into discrete portions (4') interposed between each opposing pair of said X and Y electrodes.

9. A two-dimensional image read-out device according to claim 7, wherein the thickness D of said photoconductive layer (4) and the spacing L between said electrodes satisfy the relationship L > D.

**Patentansprüche**

1. Zweidimensionale Bildlesevorrichtung mit einem aus einer regelmäßigen Anordnung optischer Abtastbereiche bestehenden Bildsensor (1), der Ausgangssignale erzeugt, die einem von der Vorrichtung gelesenen zweidimensionalen Bild (10) entsprechen, **dadurch gekennzeichnet, daß**
   - die optischen Abtastbereiche in der Art einer zweidimensionalen Matrix angeordnet sind, wobei jeder optische Abtastbereich an den Kreurungspunkten einer Mehrzahl von parallelen X-Elektroden (5; 25) und einer Mehrzahl von parallelen Y-Elektroden (3; 23) angeordnet ist,
   - die Vorrichtung optische Abtastmittel (11, 12; 30) aufweist, die aufeinanderfolgende lineare Abschnitte des Bildes auf entsprechende Zeilen der aus den Abtastbereichen bestehenden Matrix sequentiell abbilden, und daß
   - auf die Abbildung der aufeinanderfolgenden linearen Bildabschnitte ansprechende Mittel (6, 7, 8; 26, 29) vorhanden sind, die eine einem jeweiligen der linearen Bildabschnitte entsprechende Signalfolge erzeugen.

2. Zweidimensionale Bildlesevorrichtung nach Anspruch 1, **dadurch gekennzeichnet, daß**
   - die Mehrzahl von X-Elektroden (5) senktecht zur Mehrzahl von Y-Elektroden (3) angeordnet ist und sich zwischen den X- und Y-Elektroden eine photoleitfähige Schicht (4) befindet, wobei eine oder beide Elektrodenanordnungen aus transparentem Material hergestellt sind,
   - eine optische Einrichtung (9) vorhanden ist zum Projizieren der linearen Bildabschnitte auf die Abtastbereiche,
   Schalter (7) vorhanden sind zum selektiven Anlegen einer Versorgungsspannung an die entsprechenden Zeilen der aus Abtastbereichen bestehenden Matrix, und daß eine Steuereinrichtung ( 13) den Abfragevorgang der Abtastbereiche mit dem Einschaltvorgang der Elektroden synchronisiert.

3. Zweidimensionale Bildlesevorrichtung nach Anspruch 2, **dadurch gekennzeichnet**, daß die bezüglich Masse positive oder negative Versorgungsspannung einer ausgewählten Zeile der Abtastbereiche über eine ausgewählte Elektrode zugeführt wird und daß die X- und/oder Y-Elektroden auf Masse liegen, so daß der über Abtastbereiche der ausgewählten Zeile fließende Strom über einen zwischen der photoleitfähigen Schicht und Masse geschalteten Belastungwiderstand eine Ausgangsspannung liefert.

4. Zweidimensionale Bildlesevorrichtung nach Anspruch 2, **gekennzeichnet durch** Abtastschalter (29), die an entsprechende Elektroden (25) einer aus transparentem Material bestehenden Elektrodenanordnung angeschlossen sind,
   eine Spannungsquelle (28), die mit einer der transparenten Elektroden (25) und über die Abtastschalter (29) mit den übrigen Elektroden der Anordnung verbunden ist, ein optisches System (30) zur Darstellung des auszulesenden Bilds auf die transparenten Elektroden außer der einen transparenten Elektrode,
   eine tastbare Lichtquelle (26), die einen transparenten Elektrode gegenüberstehend angeordnet ist und relativ zum Sensor entlang der einen transparenten Elektrode bewegbar ist, so dabei eingeschalteter Lichtquelle ein durch die Momentanposition der Lichtquelle festgelegter Bereich der photoleitfähigen Schicht aktiviert ist und ein Stromkreis zwischen einer aus der zweiten Anordnung der Elektroden (23) ausgewählten Elektrode und der Spannungsquelle über die eine transparente Elektrode geschlossen wird.

5. Zweidimensionale Bildlesevorrichtung nach Anspruch 4, **dadurch gekennzeichnet,** daß die tastbare Lichtquelle (26) in das optische System (30) zur Bilddarstellung auf die transparenten Elektroden (25) integriert ist.

6. Zweidimensionale Bildlesevorrichtung nach Anspruch 4 oder 5, **dadurch gekennzeichnet**, daß die transparenten Elektroden (25) ausschließlich der einen zur Stromversorgung ausgewählten Elektrode selektiv an Masse gelegt oder über die Abtastschalter (29) selektiv an die Spannungsquelle (28) anschließbar sind.

7. Zweidimensionale Bildlesevorrichtung nach einem der Ansprüche 2 bis 6, **dadurch gekennzeichnet,** daß die photoleitfähige Schicht (4) sich kontinuierlich zwischen mehreren aus X- und Y-Elektroden bestehenden Paaren erstreckt.

8. Zweidimensionale Bildlesevorrichtung nach einem der Ansprüche 2 bis 6, **dadurch gekennzeichnet**, daß die photoleitfähige Schicht in diskrete Abschnitte (4') aufgeteilt ist, die jeweils zwischen den aus X- und Y-Elektroden gebildeten Paaren angeordnet sind.

9. Zweidimensionale Bildlesevorrichtung nach Anspruch 7, **dadurch gekennzeichnet**, daß die Stärke D der photoleitfähigen Schicht (4) geringer ist als der Abstand L zwischen den einzelenen Elektroden.

**Revendications**

1. Dispositif de lecture d'images en deux dimensions, comportant un capteur d'images (1) qui comprend un réseau de régions optiquement sensibles, le capteur étant conçu pour produire un signal de sortie représentant une image à deux dimensions (10) lue par le dispositif, caractérisé en ce que lesdites régions optiquement sensibles sont disposées sous la forme d'une matrice à deux dimensions, chaque région optiquement sensible étant située aux intersections d'une pluralité d'électrodes X parallèles (5; 25) et d'une pluralité d'électrodes Y parallèles (3 ; 23), et en ce que ledit dispositif comporte des moyens de balayage optiques (11. 12. 30) qui présentent des régions linéaires successives de l'image à des lignes respectives de la matrice de régions sensibles d'une manière séquentielle et des moyens (6. 7. 8. 26. 29) sensibles à la présentation desdites régions linéaires successives. qui génèrent des signaux successifs représentant chacun une région d'image linéaire correspondante.

2. Dispositif de lecture d'images à deux dimensions selon la revendication 1, dans lequel ladite pluralité d'électrodesX (5) est disposée suivant une direction perpendiculaire à celle de ladite pluralité d'électrodesY (3) et une couche photoconductrice (4) est intercalée entre lesdites électrodes X et Y, l'une des pluralités d'électrodes ou les deux étant réalisées en un matériau transparent, et dans lequel sont prévus des moyens optiques (9) destinés à projeter lesdites régions linéaires de l'image sur lesdites régions sensibles ; des moyens de commutation (7) destinés à fournir de manière sélective auxdites lignes respectives de la matrice de régions sensibles une tension d'alimentation ; et des moyens de commande (13) destinés à synchroniser le balayage des régions sensibles et la commutation des électrodes.

3. Dispositif de lecture d'images à deux dimensions selon la revendication 2, dans lequel ladite tension d'alimentation, positive ou négative par rapport à la masse, est fournie à une ligne sélectionnée de régions sensibles par l'intermédiaire d'une électrode sélectionnée parmi lesdites électrodes, et, parmi lesdites électrodes X et Y autres que ladite électrode sélectionnée, l'une des deux pluralités d'électrodes X et Y ou les deux sont mises à la masse, de sorte que le courant circulant à travers les régions sensibles de la ligne sélectionnée de celles-ci est fourni sous la forme d'une tension de sortie par l'intertermédiaire d'une résistance de charge disposée entre la couche photoconductrice et la masse.

4. Dispositif de lecture d'images à deux dimensions selon la revendication 2, dans lequel sont prévus :
   - des commutateurs de balayage (29) reliée à des électrodes respectives (25) de l'une des pluralités d'électrodes, ladite pluralité d'électrode étant transparente ;
   - une alimentation (28) branchée entre une première électrode transparente (25) et les électrodes restantes de cette pluralité par l'intermédiaire des commutateurs de balayage (29) ;
   - un système optique (30) destiné à présenter l'image à lire aux électrodes transparentes autres que ladite première électrode transparente; une source lumineuse de commutation (26) qui fait face à ladite première électrode transparente et est susceptible de se déplacer par rapport au capteur le long de ladite première électrode transparente pour que, lorsque ladite source lumineuse est mise en service, une partie de la couche photoconductrice, déterminée par la position instantanée de la source lumineuse de commutation, soit activée et qu'un trajet soit ainsi établi entre une électrode sélectionnée parmi la seconde pluralité d'électrodes (23) et l'alimentation par l'intermédiaire de ladite première électrode transparente.

5. Dispositif de lecture d'images à deux dimensions selon la revendication 4, dans lequel ladite source lumineuse de commutation (26) fait partie intégrante dudit système optique (30) destiné à présenter l'information d'image auxdites électrodes transparentes (25).

6. Dispositif de lecture d'images à deux dimensions selon la revendications 4 ou la revendication 5, dans lequel lesdites électrodes transparentes (25) autres que ladite électrode pour l'alimentation sont sélectivement mises à la masse ou reliées à ladite alimentation (28) par l'intermédiaire des commutateurs de balayage (29).

7. Dispositif de lecture d'images à deux dimensions selon l'une quelconque des revendications 2 à 6, dans lequel ladite couche photoconductrice (4) s'étend de manière continue entre les électrodes de plusieurs paires d'électrodes X et Y.

8. Dispositif de lecture d'images à deux dimensions selon l'une quelconque des revendications 2 à 6, dans lequel ladite couche photoconductrice est divisée en parties discrètes (4') intercalées entre les électrodes opposées de chacune desdites paires d'électrodes X et Y.

9. Dispositif de lecture d'image à deux dimensions selon la revendication 7, dans lequel l'épaisseur D de ladite couche photoconductrice (4) et l'écartement L entre lesdites électrodes satisfont la relation L>D.

FIG.1 (a)

FIG.1 (b)

light    dark    light

$Y_{N-1}$ L $Y_N$    $Y_{N+1}$

vertical
scanning
circuit

$E_0$

R

$7_0$    7

$Y_1$
$Y_2$

$Y_{M+1}$

$X_1$ $X_2$    $X_{N+1}$

position dectector

13

FIG.2

9

FIG.3

FIG. 4

FIG.5 (a)

FIG.5 (b)

FIG.6